# FASCICULE DE BREVET EUROPEEN

(11) **EP 0 565 427 B1**
(45) Date de publication et mention de la délivrance du brevet: **05.07.1995**
(21) Numéro de dépôt: 93400884.8
(22) Date de dépôt: 05.04.1993
(51) Int. Cl.: H05K 13/00, H05K 3/22

(54) **Dispositif de transfert de cartes de circuits imprimés pour installation de traitement thermique par convection et installation en faisant application**
Vorrichtung zum Transportieren von Leiterplatten für eine Anlage zur thermischen Behandlung durch Konvektion und Installation zu seiner Verwendung
Device for transferring printed circuit boards for an installation for thermal treatment by convection and installation therefor

(30) Priorité: 06.04.1992 FR 9204181
(43) Date de publication de la demande: 13.10.1993
(73) Titulaire: AUTOMA-TECH, F-27000 Evreux (FR)
(72) Inventeur: Sorel, Alain, F-27180 Les Baux Sainte Croix (FR); Charbonnier, Serge, F-27120 Chambray (FR)
(74) Mandataire: Dronne, Guy

(56) Documents cités:
- WO-A-90/03097
- US-A- 4 619 368

## Description

La présente invention a pour objet un dispositif de transfert de cartes de circuits imprimés pour installation de traitement thermique par convection et une installation de traitement thermique par convection en faisant application.

De façon plus précise, on sait que la fabrication de circuits imprimés et le montage de composants électroniques sur ces cartes requiert en plusieurs étapes faisant appel à des installations de traitement thermique par convection, c'est-à-dire par circulation d'air chaud ou, plus généralement, de gaz chaud à l'intérieur d'une enceinte dans laquelle les cartes sont placées aux différents stades de leur fabrication. C'est en particulier le cas des fours de polymérisation utilisés notamment pour la cuisson des encres photo imageables servant d'épargne aux pistes conductrices des circuits imprimés, cf. par exemple WO-A-90/03097.

Dans de telles installations, il est très souhaitable que la circulation par convection de l'air chaud ou du gaz chaud puisse être réalisée de telle manière que l'on obtienne une température sensiblement uniforme des cartes sur l'ensemble de leurs surfaces. En outre, il est extrêmement souhaitable que la plus grande partie de la surface de la carte de circuits imprimés soit effectivement disponible pour réaliser les pistes conductrices et les trous métallisés afin de rentabiliser le support isolant formant la carte.

Or, les installations actuellement connues sont mal adaptées pour satisfaire aux deux impératifs énoncés ci-dessus. Une des raisons de l'inadéquation de ces installations réside largement dans le type de dispositif de transfert qui est utilisé pour déplacer et maintenir les cartes de circuits imprimés à l'intérieur de l'installation et par exemple à l'intérieur du four de polymérisation. En effet, dans les installations connues, chaque carte de circuits imprimés est fixée par son bord inférieur sur un élément support qui est lui-même monté sur une chaîne sans fin d'entraînement afin de permettre le déplacement progressif de la carte dans les différentes zones du four. Ce type de dispositif de transfert des cartes présente un double inconvénient. Pour assurer un maintien convenable de la carte, le support doit pincer la carte sur sa périphérie inférieure sur une hauteur non négligeable, cette portion de la surface de la carte étant donc perdue pour la réalisation des éléments conducteurs. Typiquement cette hauteur est de l'ordre de 20 mm. En outre, l'élément support de fixation doit avoir nécessairement une certaine largeur selon la direction de déplacement des cartes afin de maintenir verticalement les cartes de façon satisfaisante, même si celles-ci présentent une hauteur non négligeable. Si, de plus, on veut avoir à l'intérieur du four des cartes qui ne soient pas trop espacées les unes des autres, on comprend que la seule solution pour créer dans le four un courant de convection d'air chaud convenable est de le créer par des orifices d'injection de l'air chaud disposés sur les parois latérales du four et sur chacune de celles-ci. Cette disposition entraîne en fait un gradient de température important sur une même pièce et favorise, à partir des solvants qui sont extraits des dépôts d'encre, la formation de condensation très défavorable. En effet, l'aspiration des vapeurs de solvants ne peut se faire de façon convenable si l'on veut conserver une circulation du gaz chaud entre les cartes qui assure un échauffement relativement homogène des cartes.

Un premier objet de l'invention est de fournir un dispositif de transfert de cartes de circuits imprimés pour installation de traitement thermique par convection qui permette de réduire très sensiblement la zone inutilisable de la carte correspondant à la surface de fixation et qui autorise la création dans l'installation d'un courant de convection d'air chaud adapté et satisfaisant aux critères énoncés ci-dessus.

Pour atteindre ce premier objet, le dispositif de transfert de cartes de circuits imprimés pour installation de traitement thermique par convection comprend une pluralité de supports de cartes, des moyens d'entraînement desdits supports dans l'installation et des moyens de fixation desdits supports sur les moyens d'entrainement, ce dispositif étant caractérisé en ce que chaque support comporte un premier montant qui, lorsque ledit support est en position verticale, fait un angle avec l'horizontale compris entre 5 et 40 degrés et un deuxième montant solidaire par une de ses extrémités dudit premier montant à son extrémité la plus basse lorsque le support est en position verticale, ledit deuxième montant étant sensiblement perpendiculaire au premier, chaque montant étant muni d'une pluralité d'éléments de maintien aptes à recevoir la périphérie de ladite carte et, en ce que lesdits moyens de solidarisation maintiennent le plan défini par les deux montants de chaque support dans un plan normal à la trajectoire des moyens d'entrainement.

On comprend que, grâce au fait que le premier montant est légèrement incliné vers le second, lorsque le support est en position verticale la carte par gravité est naturellement appliquée contre le deuxième montant qui fait un angle droit avec le premier. Ainsi la carte est maintenue non seulement par son côté inférieur mais également par un de ses côtés "verticaux". Grâce à cette disposition, il est possible de prévoir des éléments de maintien de la périphérie de la carte qui ont des dimensions très réduites et qui ne recouvrent la périphérie de la carte que sur une hauteur très limitée ce qui diminue d'autant la portion de la surface de la carte non utilisable. En outre, ces éléments de maintien peuvent être espacés et ils ne constituent pas un obstacle significatif vis-à-vis du courant de convection d'air chaud dans l'intallation.

Un deuxième objet de l'invention est de fournir une installation de traitement thermique par convection de cartes de circuits imprimés qui permette d'obtenir effectivement une grande égalité des températures auxquelles sont soumises les différentes parties des cartes des circuits imprimés sous l'effet du courant de convection du gaz chaud et qui permette de plus une évacuation satisfaisante des vapeurs de solvants provenant du chauffage des cartes de circuits imprimés.

Pour atteindre ce deuxième objet selon l'invention, l'installation de traitement thermique par convection de cartes de circuits imprimés comprend :
- une enceinte étanche allongée présentant un fond et une paroi supérieure, un dispositif de transfert de cartes de circuits imprimés du type défini précédemment pour déplacer lesdites cartes selon la direction de la longueur de ladite enceinte,
- des moyens disposés dans ledit fond de l'enceinte pour introduire dans celle-ci un gaz chaud, et
- des moyens disposés dans ladite paroi supérieure pour aspirer le gaz chaud et les vapeurs des solvants provenant desdites cartes de circuits imprimés.

On comprend que, grâce à cette installation, il est possible de créer de part et d'autre de chaque carte un courant de convection homogène de l'air chaud entre le fond et la paroi supérieure de l'enceinte ce qui permet donc d'obtenir un gradient de températures convenable. En outre, on peut effectivement aspirer à la partie supérieure de l'enceinte les gaz chauds et les vapeurs des solvants provenant de l'échauffement des dépôts réalisés sur les cartes de circuits imprimés afin d'obtenir les différentes polymérisations souhaitées.

Selon un mode préféré de réalisation de l'installation, celle-ci se caractérisé en ce qu'elle est séparée en différentes zones, chaque zone étant isolée des zones voisines par un rideau de gaz pulsé, chaque rideau étant disposé sensiblement perpendiculairement au sens de déplacement des moyens de transfert des cartes.

D'autres caractéristiques et avantages de l'invention apparaîtront plus clairement à la lecture de la description qui suit de plusieurs modes de réalisation de l'invention donnés à titre d'exemples non limitatifs.

La description se réfère aux figures annexées sur lesquelles :
- la figure 1 montre en position verticale un support sur lequel est placée une carte ;
- la figure 2 montre un élément de maintien des cartes selon la ligne II-II de la figure 1 ;
- la figure 3 montre une vue d'extrémité de l'installation de traitement présentant les supports montés sur la chaîne d'entraînement ;
- la figure 4 est une vue latérale partielle de l'installation de traitement de la figure 3 ;
- la figure 5 est une vue de dessus de l'installation de la figure 4 ;
- la figure 6 est une vue de dessus montrant la façon dont une carte de circuits imprimés est mise en place sur un support ; et
- la figure 7 est une vue de dessus de l'installation de traitement, illustrant schématiquement les flux d'air dans l'installation.

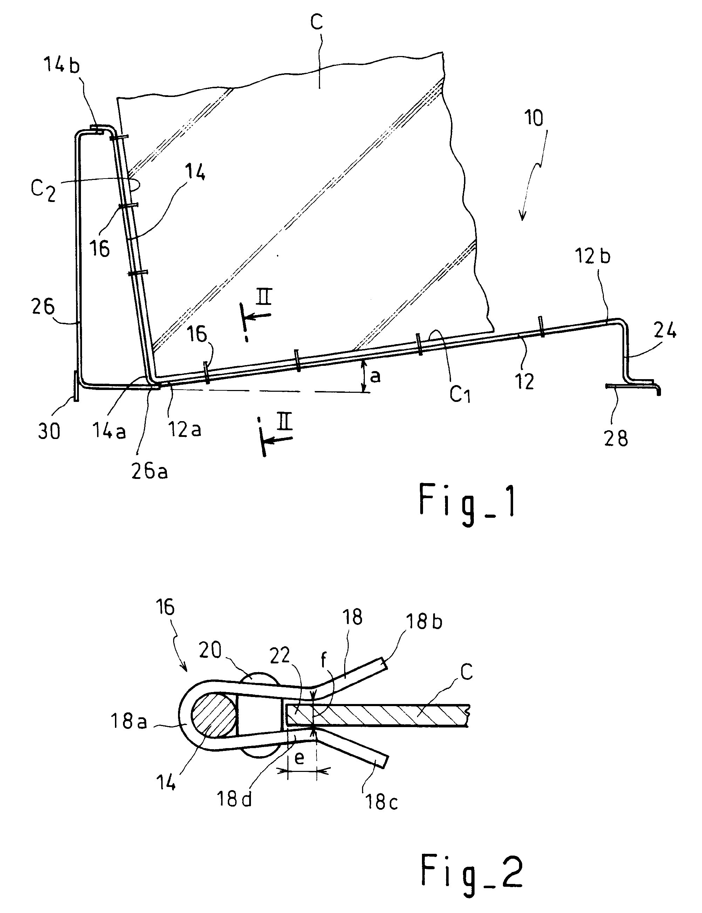

En se référant tout d'abord aux figures 1 et 2, on va décrire un mode préféré de réalisation du support de cartes de circuits imprimés selon l'invention.

Comme le montre la figure 1, l'élément support 10 est essentiellement constitué par un premier montant 12 qui, lorsque le support 10 est en position verticale fait un angle a avec l'horizontale. L'angle a est compris entre 5 et 40 degrés et il vaut de préférence 7 degrés 30 minutes. Le support 10 comporte également un deuxième montant 14 qui est orthogonal au montant 12 et dont l'extrémité inférieure 14a est raccordée à l'extrémité inférieure 12a du montant 12, c'est-à-dire son extrémité la plus basse lorsque le support 10 est en position verticale. De préférence, les montants 12 et 14 sont constitués par une même tige coudée à angle droit. La tige a par exemple un diamètre de l'ordre de 8 mm pour présenter une rigidité suffisante. Les montants 12 et 14 sont munis d'éléments de maintien portant la référence générale 16 qui sont régulièrement espacés sur les montants 12 et 14.

La figure 2 montre plus clairement un exemple de réalisation d'un élément de maintien 16. Celui-ci est formé par une tôle 18 en forme générale de U dont la partie semi circulaire 18a entoure la tige formant un montant 12 ou 14 et qui est associée à un élément de solidarisation 20 afin de solidariser la pièce 18 avec le montant 14 tout en présentant une possibilité de réglage en rotation. Comme on le voit mieux les extrémités des branches de la pièce 18 qui sont référencées 18b et 18c sont évasées tandis que les portions de cette même pièce à proximité de la pièce de maintien 20 et qui sont référencées 18d sont sensiblement parallèles. Les portions 18d ont une profondeur égale à e qui est de l'ordre de 5 mm. Comme le montre la figure 2, une carte de circuits imprimés C est engagée par sa périphérie 22 entre les portions 18d de la pièce 18 de l'élément de maintien. L'écartement f entre les deux portions 18d de l'élément de maintien est sensiblement égal à l'épaisseur de la carte C. En outre, on comprend que les extrémités évasées 18b et 18c des éléments de maintien favorisent la mise en place de la périphérie de la carte entre les portions de maintien 18d.

Afin de maintenir l'élément support dans sa position représentée sur la figure 1 et de permettre sa fixation sur une chaîne d'entraînement qui sera décrite ultérieurement, des éléments de fixation sont prévus. Ils comprennent d'une part, une tige de fixation 24 solidaire de la deuxième extrémité 12b du premier montant 12 et d'autre part par une tige verticale 26 coudée dont une première extrémité 26a est fixée au point commun des montants 12 et 14 et dont l'autre extrémité est solidire de la deuxième extrémité 14b du montant 14. Les tiges 24 et 26 comportent chacune des pattes de fixation respectivement référencées 28 et 30.

On comprend dès à présent les avantages du support 10 selon l'invention. Lors du transport des cartes de circuits imprimés C par les supports 10 et lorsque ceux-ci sont en position verticale la carte C par l'effet de son propre poids et en raison de l'inclinaison du premier montant 12 est en permanence appuyée contre le montant 14 ou plus précisément contre les éléments de maintien 16 de celui-ci. Ainsi, la carte est maintenue en place sur le support 10 par son bord inférieur C1 et par son bord gauche C2 sur la figure 1. Ce double maintien en particulier le maintien du bord C2 par le montant 14 permet de réduire très considérablement le volume des éléments de maintien 16. Comme on l'a déjà expliqué en liaison avec la figure 2, ceux-ci se réduisent à des éléments de tôle de largeur réduite 18 qui enserrent la périphérie de la carte sur une profondeur réduite.

Il en résulte que tout en assurant un maintien convenable des cartes de circuits imprimés C sur les supports, ceux-ci ont une épaisseur très limitée par rapport au support de l'état de la technique et ils ne perturbent donc pas, comme on l'expliquera ultérieurement, la circulation d'air dans l'installation de traitement thermique par convection. En outre, la profondeur e sur laquelle la périphérie des cartes est enserrée étant réduite la portion préservée des cartes sur lesquelles aucun circuit ne peut être réalisé est donc limitée. La profondeur e est typiquement de 5 mm.

Comme on l'a déjà indiqué, le dispositif de transfert des cartes de circuits imprimés est constitué par une pluralité de supports tels que 10 qui sont solidarisés avec des chaînes d'entraînement sans fin, chaque élément support étant fixé de façon convenable sur les chaînes par l'intermédiaire des pattes de fixation 28 et 30.

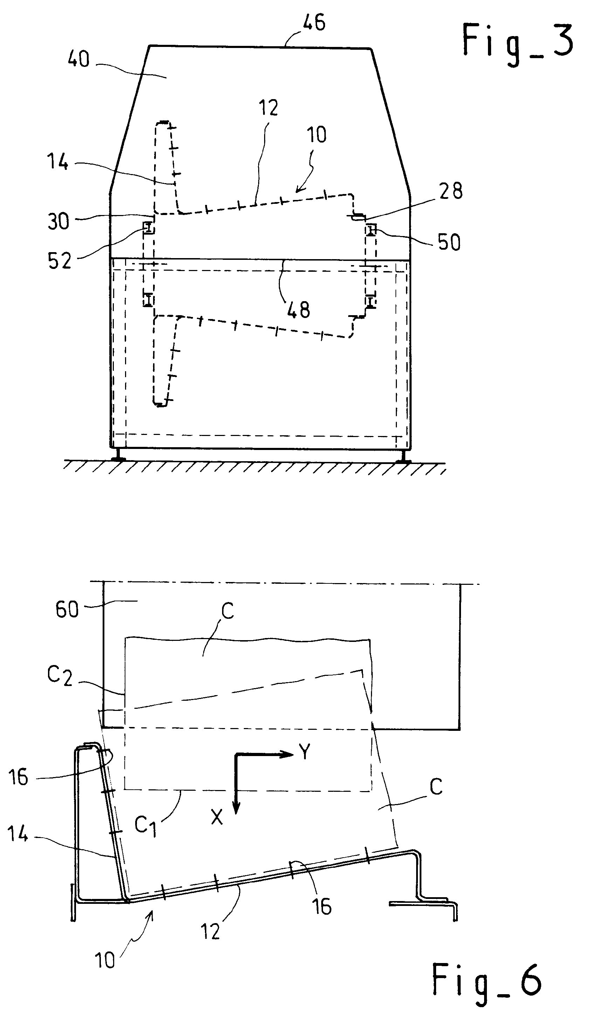

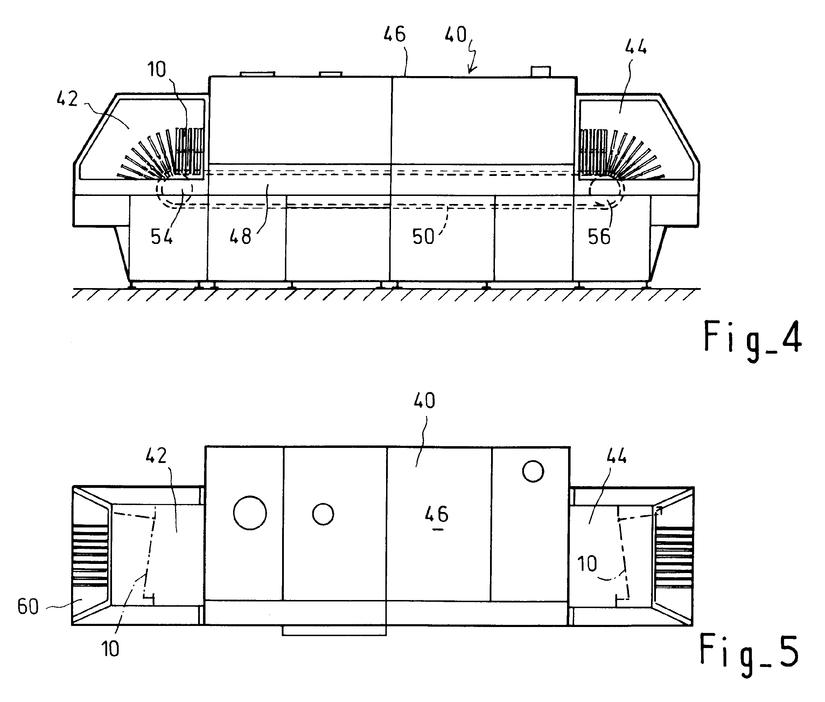

En se référant maintenant aux figures 3 à 5, on va décrire un exemple d'installation dans laquelle est monté le dispositif de transfert de cartes à circuits imprimés. L'installation comporte une enceinte de forme allongée 40 comportant à une première extrémité un poste 42 de chargement des cartes C sur les supports 10 et à son autre extrémité un poste de déchargement 44 de ces mêmes cartes. L'enceinte 40 comporte notamment une paroi supérieure 46 et une paroi inférieure 48 comme on l'expliquera ultérieurement. Les éléments supports sont montés par leurs pattes de fixation 28 et 30 sur deux chaînes sans fin 50 et 52 parallèles entraînées aux extrémités de l'enceinte 40 par des paires de roues dentées 54 et 56. Le mode de fixation des supports 10 sur les chaînes 50 et 52 est tel que le plan de chaque support 10 est défini par les montants 12 et 14 dans un plan qui est normal au trajet des chaînes d'entraînement 50 et 52. Comme le montre schématiquement la figure 4, les supports 10 sont ainsi en position verticale lorsqu'ils traversent l'enceinte 40 et ils passent par une position horizontale aux postes de chargement 42 et de déchargement 44.

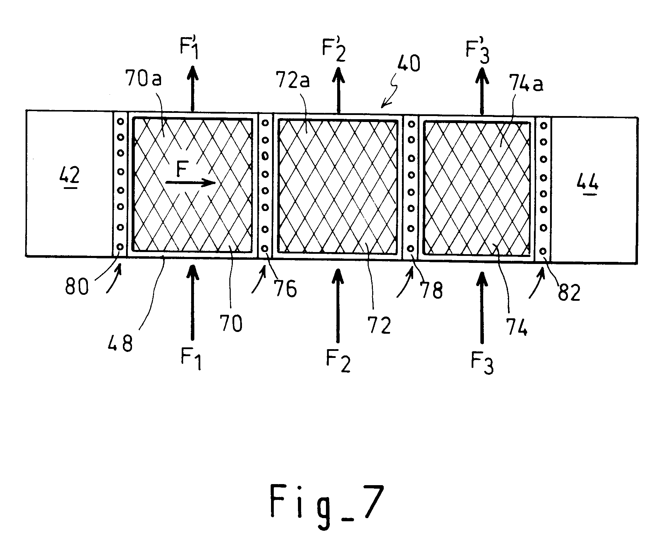

En se référant plus particulièrement à la figure 6, on va expliquer comment chaque carte C est mise en place sur un support 10. Au poste de chargement 42, le support 10 passe par une position horizontale. La carte C à charger est amenée par une table d'entraînement 60 en X et en Y de type en soi connu. La carte peut ainsi se déplacer librement et être entraînée librement selon toutes les directions du plan horizontal par combinaison des déplacements selon les deux axes orthogonaux X et Y. La carte est entraînée notamment dans la direction X en direction du support 10, celui-ci étant en position horizontale. Les bords C1 et C2 de la carte C sont ainsi progressivement engagées dans les éléments de maintien 16 des montants 12 et 14 du support 10. A la fin de cette phase, les chaînes d'entraînement provoquent le relèvement progressif de l'élément du support 10 jusqu'à ce que celui-ci arrive en position verticale pour traverser l'enceinte de traitement 40 proprement dite. Comme on l'a déjà expliqué, en raison de l'inclinaison du montant 12,le côté C2 de la carte est toujours maintenu dans les éléments de maintien 16 du montant 14. On obtient ainsi un très bon maintien des cartes C sur les supports 10 durant toute leur traversée de l'enceinte de traitement 40. On comprend de plus que l'inclinaison du montant 14 par rapport à la direction X et l'inclinaison du montant 12 par rapport à la direction Y favorisent la mise en place de la carte correcte dans les éléments de maintien sous l'effet de l'entraînement par la table.

En se référant maintenant plus particulièrement à la figure 7, on va décrire plus en détails un mode préféré de réalisation du four de polymérisation selon l'invention. Celui-ci est équipé d'un dispositif de transfert de plaque du type déjà décrit.

L'enceinte 40 est divisée en trois zones respectivement référencées 70, 72 et 74 disposées cote à cote. Les zones sont séparées par des rideaux verticaux d'air pulsé créés par des lignes de buses d'injection d'air sous pression disposées perpendiculairement à la direction F de déplacement des supports 10 dans l'enceinte. Les buses 76 et 78 séparant la zone 72 des zones 70 et 74 sont alimentées en air chaud et les alignements de buses 80 et 82 séparant l'enceinte proprement dite 40 des zones de chargement 42 et de déchargement 44 des cartes sont alimentés en air froid. Les rideaux d'air pulsé s'étendent du plateau 48 où ils sont créés jusqu'à la paroi supérieure de l'enceinte. Les trois zones 70 à 74 sont effectivement isolées les unes des autres tout en permettant le passage des supports 10 avec leurs cartes C d'une zone à l'autre.

Dans chaque zone 70 à 74, on introduit de l'air chaud à une température convenable à travers des grilles 70a, 72a et 74a montées sur le plateau 48 et qui sont donc disposées sur la paroi inférieure de l'enceinte 40. L'air ainsi introduit à la partie inférieure de chaque zone est repris par des cheminées d'aspiration disposées dans la paroi supérieure de l'enceinte. Les flèches F1, F2 et F3 représentent l'alimentation en air chaud des grilles tandis que les flèches F′1, F′2 et F′3 représentent l'aspiration de cet air en partie supérieure des zones.

On obtient ainsi une circulation de l'air entre les diffférentes cartes du bas vers le haut de l'enceinte. Les cheminées d'aspiration permettent donc une aspiration et, donc, une évacuation efficace des vapeurs de solvants extraits des produits disposés sur les cartes lors du chauffage de celles-ci. On évite ainsi le phénomène de condensation de ces vapeurs. En outre, comme les montants inférieurs 12 des supports de cartes ainsi que les éléments de maintien 16 montés sur ceux-ci ne constituent pas des obstacles significatifs pour la circulation ascendante de l'air sortant des trous régulièrement répartis des grilles 70a, 72a et 74a à la base de chaque zone.

De plus, l'air injecté par les grilles inférieures dont les orifices sont régulièrement répartis se divise en flux ascendant régulièrement réparti entre les cartes C. On obtient ainsi un gradient homogène de température des cartes aussi bien en ce qui concerne les différentes parties d'une même carte qu'en ce qui concerne les cartes les unes par rapport aux autres dans une même zone.

En outre, la quasi-totalité des vapeurs de solvants est aspirée dans les zones 70 et 72. L'air injecté dans la zone 74 est donc "propre" lorsqu'il est aspiré en F3. Cet air peut donc servir à alimenter les grilles 70a et 72a des zones 70 et 72. Cela permet de réduire l'énergie nécessaire pour porter l'air injecté dans ces zones à sa température requise.

Il est important de souligner que le dispositif de transfert des cartes peut être utilisé pour des cartes de formats très différents sans que cela ne nécessite de réglages particuliers. En effet, chaque montant 12 et 14 est muni d'une pluralité d'éléments de maintien régulièrement espacés. Les seules limites consistent donc dans l'intervalle entre deux éléments de maintien, pour que le bord de la carte soit effectivement tenu par au moins deux éléments de maintien 16. En outre, du fait que les différentes zones de l'enceinte ne sont séparées que par des rideaux d'air pulsé, l'étanchéité est obtenue indépendamment des dimensions des cartes transportées.

## Revendications

1. Dispositif de transfert de cartes (C) de circuits imprimés pour installation de traitement thermique par convection, comprenant une pluralité de supports (10) de cartes, des moyens d'entraînement (50, 52) desdits supports dans l'installation et des moyens de fixation desdits supports sur les moyens d'entrainement, et étant caractérisé en ce que chaque support comporte un premier montant (12) qui, lorsque ledit support est en position verticale, fait un angle a avec l'horizontale compris entre 5 et 40 degrés et un deuxième montant (14) solidaire par une de ses extrémités (14a) dudit premier montant à son extrémité la plus basse (12) lorsque le support est en position verticale, ledit deuxième montant étant sensiblement perpendiculaire au premier, chaque montant étant muni d'une pluralité d'éléments de maintien (16) aptes à recevoir la périphérie (C1, C2) de ladite carte et, en ce que lesdits moyens de solidarisation maintiennent le plan défini par les deux montants (12, 14) de chaque support dans un plan normal à la trajectoire des moyens d'entrainement (50, 52).

2. Dispositif de transfert selon la revendication 1, caractérisé en ce que chaque élément de maintien (16) est formé par une pièce (18) en forme de U dont la portion courbe (18a) est solidaire du montant (12,14) sur lequel il est monté et dont les branches s'étendant à l'intérieur de la zone définie par les deux montants sont aptes à recevoir la périphérie (C1, C2) de chaque carte (C).

3. Dispositif de transfert selon l'une quelconque des revendications 1 et 2, caractérisé en ce que lesdits premiers montants (12) des supports (10) sont solidarisés sur les moyens d'entraînement de telle manière qu'ils s'étendent sensiblement perpendiculairement à la direction d'entraînement desdits supports.

4. Dispositif de transfert selon l'une quelconque des revendications 1 et 2, caractérisé en ce que les moyens d'entraînement comprennent deux chaînes (50, 52) sans fin montées sur des roues dentées d'entraînement.

5. Dispositif de transfert selon la revendication 4, caractérisé en ce que l'extrémité (12a, 12b) d'un premier montant (12) est solidarisée avec une des chaînes d'entraînement par des éléments de fixation (24, 28, 26, 30) pour que ledit premier montant (12) fasse l'angle (a) avec le segment défini par les deux points de fixation dudit montant sur lesdites chaînes.

6. Dispositif de transfert selon l'une quelconque des revendications 1 à 5, caractérisé en ce que ledit angle (a) est de l'ordre de 7°30′.

7. Installation de traitement thermique par convection de cartes de circuit imprimé, comprenant :
- une enceinte étanche (40) allongée présentant une paroi inférieure (48) et une paroi supérieure (46) ;
- un dispositif de transfert de cartes selon l'une quelconque des revendications 1 à 6, pour déplacer lesdites cartes (C) selon la direction (F) de la longueur de ladite enceinte ;
- des moyens (70a, 72a, 74a) disposés dans ladite paroi inférieure (48) pour introduire dans ladite enceinte un gaz chaud ; et
- des moyens (F′1, F′2, F′3) disposés dans ladite paroi supérieure (46) pour aspirer ledit gaz chaud et les vapeurs de solvants provenant desdites cartes de circuits imprimés.

8. Installation de traitement thermique selon la revendication 7, caractérisé en ce que ladite enceinte (40) est divisée selon le sens de sa longueur en une pluralité de zones (70, 72, 74) séparées les unes des autres et de l'extérieur, aux extrémités de ladite enceinte (40), par des rideaux d'air pulsé verticaux (76 à 82) disposés perpendiculairement à la direction (F) de déplacement desdites cartes, et s'étendant de la paroi inférieure (48) à la paroi supérieure (46) de ladite enceinte (40).

9. Installation de traitement thermique selon la revendication 8, caractérisée en ce que chaque rideau d'air est produit par un alignement de buses (76, 78, 80, 82) montées dans ladite paroi inférieure (48) et disposé entre deux zones adjacentes (70, 72, 74) ou entre une zone et l'extérieur.

## Patentansprüche

1. Vorrichtung zum Transportieren gedruckter Leiterplatten (C) für eine Anlage zur Wärmebehandlung durch Konvektion, mit mehreren Plattenträgern (10), einem Antrieb (50, 52) für die Träger in der Anlage und Mitteln zum Befestigen der Träger auf dem Antrieb,
dadurch gekennzeichnet, daß jeder Träger einen ersten Schenkel (12) aufweist, der, wenn der Träger eine vertikale Lage einnimmt, mit der Horizontalen einen Winkel zwischen 5° und 40° bildet, und einen zweiten Schenkel (14), der an einem seiner Enden (14a) fest mit dem ersten Schenkel an dessen, wenn der Träger eine vertikale Lage einnimmmt, unterstem Ende verbunden ist, wobei der zweite Schenkel im wesentlichen senkrecht zum ersten angeordnet ist und jeder Schenkel mehrere Halteelemente (16) zum Aufnehmen des Umfangs (C1, C2) der Platte aufweist, und daß die Befestigungsmittel die durch die beiden Schenkel (12, 14) festgelegte Ebene jedes Trägers in einer zur Bewegungsbahn des Antriebs (50, 52) normalen Ebene halten.

2. Vorrichtung zum Transportieren nach Anspruch 1,
dadurch gekennzeichnet, daß jedes Halteelement (16) von einem U-förmigen Teil (18) gebildet ist, dessen gekrümmter Abschnitt (18a) fest mit demjenigen Schenkel (12, 14) verbunden ist, an dem es angebracht ist, und dessen sich ins Innere des von den zwei Schenkeln festgelegten Bereichs erstreckende Zweige imstande sind, den Umfang (C1, C2) jeder Platte (C) aufzunehmen.

3. Vorrichtung zum Transportieren nach Anspruch 1 oder 2,
dadurch gekennzeichnet, daß die ersten Schenkel (12) der Träger (10) auf dem Antrieb derart befestigt sind, daß sie sich im wesentlichen senkrecht zur Antriebsrichtung der Träger erstrekken.

4. Vorrichtung zum Transportieren nach Anspruch 1 oder 2,
dadurch gekennzeichnet, daß der Antrieb zwei endlose, auf Antriebszahnrädern angeordnete Ketten (50, 52) aufweist.

5. Vorrichtung zum Transportieren nach Anspruch 4,
dadurch gekennzeichnet, daß das Ende (12a, 12b) eines ersten Schenkels (12) an einer der Antriebsketten mit Befestigungselementen (24, 28, 26, 30) befestigt ist, so daß der erste Schenkel (12) mit dem durch die zwei Befestigungspunkte dieses Schenkels auf den Ketten festgelegten Abschnitt den Winkel (a) bildet.

6. Vorrichtung zum Transportieren nach einem der Ansprüche 1 bis 5,
dadurch gekennzeichnet, daß der Winkel (a) die Größenordnung von 7°30′ hat.

7. Anlage zur Wärmebehandlung gedruckter Leiterplatten durch Konvektion, mit:
- einem dichten länglichen Behälter (40), der eine untere Wand (48) und eine obere Wand (46) aufweist,
- einer Vorrichtung zum Transportieren von Platten nach einem der Ansprüche 1 bis 6, um die Platten (C) in Längsrichtung (F) des Behälters zu bewegen,
- in der unteren Wand (48) angeordneten Mitteln (70a, 72a, 74a) zum Zuführen eines warmen Gases in den Behälter, und
- in der oberen Wand (46) angeordneten Mitteln (F′1, F′2, F′3) zum Absaugen des warmen Gases und von Lösungsmitteldämpfen, die von den gedruckten Leiterplatten stammen.

8. Anlage zur Wärmebehandlung nach Anspruch 7,
dadurch gekennzeichnet, daß der Behälter (40) der Länge nach in mehrere Bereiche (70, 72, 74) unterteilt ist, die voneinander und, an den Enden des Behälters (40), von der äußeren Umgebung durch vertikale Vorhänge (76 bis 82) pulsierender Luft getrennt sind, die senkrecht zur Bewegungsrichtung (F) der Platten angeordnet sind und sich von der unteren Wand (48) zur oberen Wand (46) des Behälters (40) erstrecken.

9. Anlage zur Wärmebehandlung nach Anspruch 8,
dadurch gekennzeichnet, daß jeder Luftvorhang von einer Anordnung von Düsen (76, 78, 80, 82) erzeugt ist, die in der unteren Wand (48) eingebaut und zwischen zwei benachbarten Bereichen (70, 72, 74) oder zwischen einem Bereich und der äußeren Umgebung angeordnet sind.

## Claims

1. Device for transferring printed circuit boards (C) for an installation for thermal treatment by convection, comprising a plurality of board carriers (10), drive means (50, 52) for driving the said carriers into the installation and fixing means for fixing the said carriers to the drive means, and being characterised in that each carrier includes a first upright (12) which forms an angle a with the horizontal of between 5 and 40 degrees when the said carrier is in the vertical position and a second upright (14) integral via one its ends (14a) with the said first upright at its lowermost end (12) when the carrier is in the vertical position, the said second upright being substantially perpendicular to the first, each upright being provided with a plurality of holding elements (16) adapted to receive the periphery (C1, C2) of the said board, and in that the said interlocking means keep the plane defined by the two uprights (12, 14) of each carrier in a plane normal to the trajectory of the drive means (50, 52).

2. Transfer device according to claim 1, characterised in that each holding element (16) is formed by a U-shaped component (18), the curved portion (18a) of which is integral with the upright (12, 14) on which it is mounted and the legs of which extending into the interior of the zone defined by the two uprights are adapted to receive the periphery (C1, C2) of each board (C).

3. Transfer device according to either of claims 1 and 2, characterised in that the said first uprights (12) of the carriers (10) are locked on to the drive means in such a manner that they extend substantially perpendicularly to the direction in which the said carriers are driven.

4. Transfer device according to either of claims 1 and 2, characterised in that the drive means comprise two endless chains (50, 52) mounted on toothed driving wheels.

5. Transfer device according to claim 4, characterised in that the end (12a, 12b) of a first upright (12) is made integral with one of the driving chains via fixing elements (24, 28, 26, 30) so that the said first upright (12) forms the angle (a) with the segment defined by the two fixing points of the said upright on to the said chains.

6. Transfer device according to any one of claims 1 to 5, characterised in that the said angle (a) is approximately 7°30′.

7. Installation for thermal treatment by convection of printed circuit boards, comprising:
- an elongated sealed enclosure (40) having a lower wall (48) and an upper wall (46);
- a device for transferring boards according to any one of claims 1 to 6, in order to displace the said boards (C) in the longitudinal direction (F) of the said enclosure;
- means (70a, 72a, 74a) disposed in the said lower wall (48) for introducing a hot gas into the said enclosure, and
- means (F′1, F′2, F′3) disposed in the said upper wall (46) for exhausting the said hot gas and the solvent vapours originating from the said printed circuit boards.

8. Thermal treatment installation according to claim 7, characterised in that the said enclosure (40) is divided in the longitudinal direction into a plurality of zones (70, 72, 74) separated from one another and from the exterior at the ends of the said enclosure (40) by vertical forced-air curtains (76 to 82) disposed perpendicularly to the direction (F) of displacement of the said boards and extending from the lower wall (48) to the upper wall (46) of the said enclosure (40).

9. Thermal treatment installation according to claim 8, characterised in that each air curtain is produced by a row of nozzles (76, 78, 80, 82) mounted in the said lower wall (48) and disposed between two adjacent zones (70, 72, 74) or between one zone and the exterior.
